# EUROPEAN PATENT SPECIFICATION

(11) **EP 3 797 335 B1**
(45) Date of publication and mention of the grant of the patent: **26.08.2026**
(21) Application number: 20722293.6
(22) Date of filing: 24.04.2020
(51) Int. Cl.: G03F 7/20

(54) **APPARATUS AND METHOD FOR EXPOSING PRINTING PLATES USING LIGHT EMITTING DIODES**
VORRICHTUNG UND VERFAHREN ZUR BELICHTUNG VON DRUCKPLATTEN UNTER VERWENDUNG VON LEUCHTDIODEN
APPAREIL ET PROCÉDÉ D'EXPOSITION DE PLAQUES D'IMPRESSION À L'AIDE DE DIODES ÉLECTROLUMINESCENTES

(30) Priority: 26.04.2019 US 201962839171 P
(43) Date of publication of application: 31.03.2021
(73) Proprietor: Esko-Graphics Imaging GmbH, 25524 Itzehoe (DE)
(72) Inventor: SIEVERS, Wolfgang, 25569 Kremperheide (DE); KLEIN, Thomas, 38302 Wolfenbuettel (DE)
(74) Representative: Müller-Boré & Partner Patentanwälte PartG mbB
(86) International application number: PCT/EP2020/061556
(87) International publication number: WO 2020/216948

(56) References cited:
- US-A1- 2008 280 227
- US-A1- 2009 002 669
- US-A1- 2009 267 269
- US-A1- 2014 057 207
- US-A1- 2018 210 344

## Description

### BACKGROUND OF THE INVENTION

The use of Light-emitting diode (LED) technology has become popular in many technical applications, such as the field of curing photopolymer printing plates, in which LEDs displace fluorescent tubes. LEDs are a desirable radiation source for curing photopolymer printing plates because of their excellent short-term and good long-term stability.

Various systems and processes for curing printing plates by exposure to a functional energy source are known, including methods for providing curing radiation using LEDs, such as is described in U.S. Patent No. 9,315,009, titled EXPOSING PRINTING PLATES USING LIGHT EMITTING DIODES and U.S. Patent No. 8,578,854, titled CURING OF PHOTO-CURABLE PRINTING PLATES USING A LIGHT TUNNEL OF MIRRORED WALLS AND HAVING A POLYGONAL CROSS-SECTION LIKE A KALEIDOSCOPE.

LEDs are typically characterized by reference to their center emission wavelength. US 9315009 describes the use of arrays in which LEDs of different center wavelengths, all in the ultraviolet (UV) spectrum, are used for curing sheet photopolymers. Using an array of UV LEDs of different wavelengths in curing a printing plate may produce flexographic printing dots having desirable geometric characteristics. Using an array of UV LEDs of different wavelengths may have advantages not only for exposure of the front, image-containing side of the plate that receives ink for transferring a printed image to a substrate, but also for exposure of the non-printing, back side of the plate.

Furthermore, US 2014/057207 A1 relates to a method of tailoring the shape of a plurality of relief printing dots created in a photosensitive printing blank during a platemaking process. The photocurable layer is exposed to actinic radiation using an array of UV LED light assemblies and the use of the array of UV LED light assemblies produces relief printing dots having at least one geometric characteristic selected from the group consisting of a desired planarity of a top surface of the relief printing dots, a desired shoulder angle of the relief printing dots and a desired edge sharpness of the relief printing dots.

Accordingly, there remains a need in the art to provide an array of discrete LEDs having multiple center emission wavelengths that provides for stable, reproducible exposure of photopolymer plates.

### SUMMARY OF THE INVENTION

The invention is defined by the subject-matter of the independent claims, Preferred embodiments are defined by the dependent claims. Exemplary embodiments of the invention include an apparatus for irradiating a printing plate having a photosensitive polymer. The apparatus includes a plurality of light-emitting diodes arranged in an array of columns and rows, such as in a chip on board (COB) configuration comprising each LED in the form of an integrated (IC) circuit chip mounted on a printed circuit board (PCB), or a surface mount design (SMD) LED, in which LEDs in discrete housings are surface mounted on a substrate. Each LED has an emission pattern, and the plurality of LEDs includes one or more members of at least a first species of LED having a first center emission wavelength, one or more members of a second species of LED having at least a second center emission wavelength and, in some embodiments, one or more members of a third species of LED having at least a third center emission wavelength. The second center emission wavelength is different than the first center emission wavelength, and the third center emission wavelength different than the first and second center emission wavelengths. The array is configured with the respective species of LEDs disposed adjacent one another in a repeating sequence of the first species, the second species and the third species (in embodiments having at least three species). The apparatus also includes at least one controller connected to the LED array. A controller is configured to independently control each species and to activate the LED array to cause all species of LEDs to emit radiation toward the printing plate simultaneously with emissions patterns of adjacent members of the different species of LED overlapping with one another on the plate.

According to the invention, the array is positioned to expose a back, non-printing side of the printing plate.

In a further embodiment, a system including a first apparatus as described herein is positioned to expose a back, non-printing side of the printing plate and a second apparatus as described herein, positioned to expose a front, printing side of the printing plate.

In some embodiments, the array may comprise a unit configured to irradiate less than a full first dimension and less than a full second dimension of the plate. A plurality of units may be arranged to form a linear source configured to irradiate the full first dimension of the plate simultaneously but less than the full second dimension of the plate simultaneously, with the exposure system further comprising means for providing relative movement between the plate and the linear source along the second direction. In other embodiments, a plurality of units may be arranged to form a source configured to irradiate the full first dimension of the plate and the full second dimension of the plate simultaneously. The units may be configurable to permit one unit to emit a different emission characteristic than another unit simultaneously, to permit the same unit to emit different emission characteristics during different portions of an exposure duration, or a combination thereof. The different radiation characteristic may include, for example, a different collective emission intensity or a different blend of relative emission intensities from the respective species. Methods for exposing a printing plate using such exposure systems may include controlling at least one unit to provide a different radiation characteristic than at least one other unit simultaneously, or to provide a first radiation characteristic in a first portion of an exposure duration, such as a first portion of relative motion or in a first step of a multi-step exposure, and a second radiation characteristic in a second portion of the exposure duration.

### BRIEF DESCRIPTION OF THE DRAWINGS

FIG. 1 illustrates a schematic diagram of an exemplary drum apparatus for exposing a printing plate to radiation.
FIG. 2A illustrates a schematic diagram of an exemplary flatbed apparatus for exposing a printing plate to radiation.
FIG. 2B illustrates a schematic diagram of another exemplary flatbed apparatus for exposing a printing plate to radiation.
FIG. 2C is a schematic drawing depicting an apparatus for front and back exposure of a photosensitive printing plate in a drum configuration.
FIG. 3A illustrates an exemplary array of two LED species of different wavelengths.
FIG. 3B illustrates an exemplary configuration for an array of three LED species of different wavelengths.
FIG. 3C illustrates another exemplary configuration for an array of three LED species of different wavelengths.
FIG. 3D illustrates an exemplary array of four LED species of different wavelengths, including a subarray schematically showing LEDs of common species connected together.
FIG. 4A illustrates an exemplary overlap of individual LED species of different wavelengths on a printing plate.
FIG. 4B illustrates an exemplary polymer plate moving sequentially through the emission patterns of individual LED species of different wavelengths.
FIG. 5A is a side-view diagram of an exemplary SMD LED array assembly on a multilayer PCB (depicted in cross-section along line C-C depicted in FIG. 5B) mounted on a cooling plate, showing an exemplary location for the driving electronics of one species of LEDs.
FIG. 5B is a plan-view diagram of the exemplary SMD LED array of FIG. 5A, showing only a single diagonal of one species of LEDs, for reduced clutter.

### DETAILED DESCRIPTION OF THE INVENTION

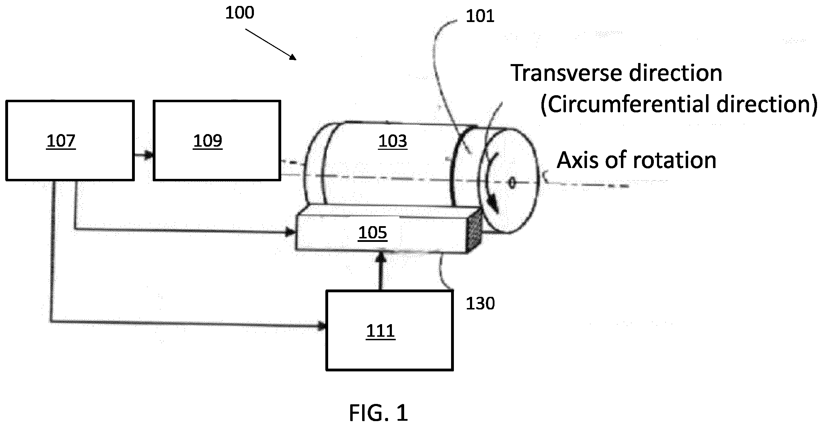

Referring now to the figures, FIG. 1 schematically illustrates an apparatus 100 including components configured to expose a printing plate having a photosensitive polymer cured by exposure to radiation. The apparatus 100 includes a rotating drum 101 with a polymer plate 103 thereon. As known in the art, plate 103 may be an imaged plate having an the image mask disposed over the photosensitive polymer layer, so that the mask blocks or permits exposure of the plate material underneath. An exposure unit 105 configured to emit the curing radiation (e.g. UV light) 105 is disposed as a linear source parallel to the drum axis in a longitudinal direction. It should be understood that the UV "light" may be in the visible or non-visible spectrum, and that the terms "radiation" and light may be used interchangeably herein, in which the term "light" does not imply a limitation to only visible radiation. The radiation may be any type of actinic radiation in any portion of the electromagnetic spectrum capable of causing a chemical reaction in the subject plate to be cured.

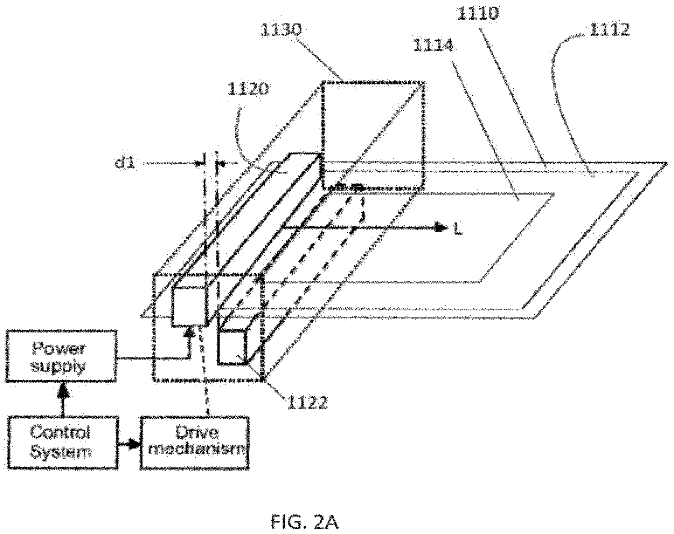

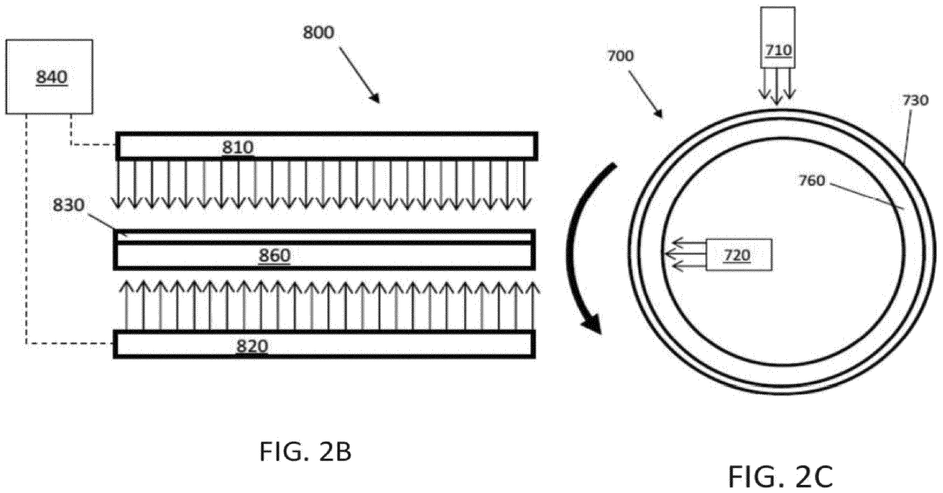

In some embodiments, exposure unit 105 may cover less than the full width of the plate on the drum and may raster back and forth in the longitudinal direction. In other embodiments, exposure unit 105 is configured to cover the full width of the plate mounting area of the drum, and remains stationary. Although shown with the plate mounted on a drum in FIG. 1, it should be understood that the plate and radiation source may instead be configured in a flatbed arrangement, such as is depicted in FIGS. 2A and 2B, described herein later. Controller 107 is connected to drive mechanism 109, power supply 111 and exposure unit 105.

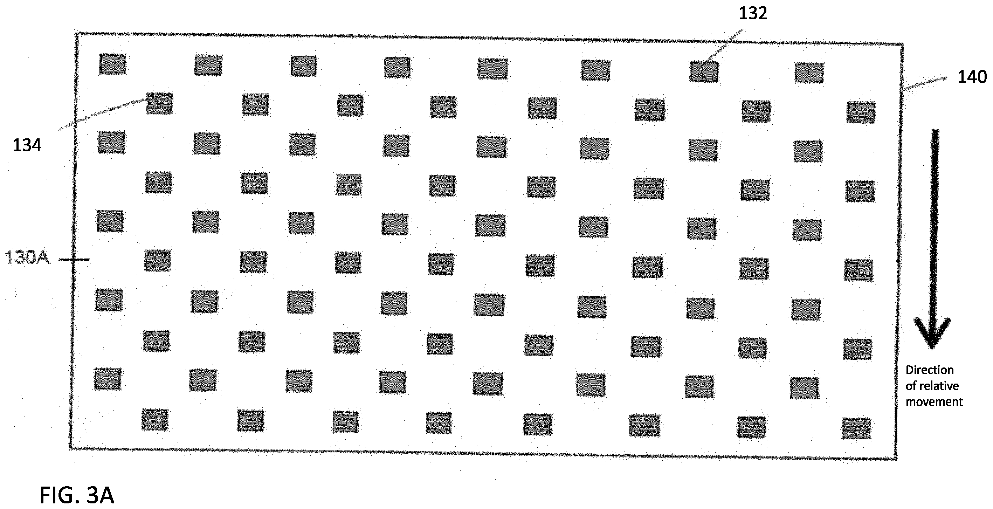

In one embodiment, the light exposure unit 105 includes a plurality of LEDs arranged in an LED array, such as in one of the exemplary arrays 130A-130E depicted in FIGS. 3A-3E. In some embodiments, each LED comprises an integrated circuit (IC) chip, and a plurality of chips are arranged in an array of rows on substrate 140. The array may be in a form in which the plurality of LEDs are configured in a "chip-on-board" (COB) configuration, or as a plurality of discrete surface mount design (SMD) LEDs mounted on substrate 140, which may be any substrate known in the art on which SMD LEDs may be mounted, such as a printed circuit board (PCB), as discussed further herein.

In the embodiment depicted in FIG. 3A, alternating rows of UV LEDs in the LED array 130A may have different wavelengths. LED array 130A includes a first species of LEDs 132 having a first center wavelength and a second species of LEDs 134 having a second center wavelength different from the first center wavelength. In general, as discussed herein, all of the LEDs emit radiation (which may be visible light or non-visible) in a range suitable for curing printing plate photopolymers. Accordingly, the LEDs typically have wavelengths in the UV or near UV range, preferably in the wavelength range of about 320 nm to about 420 nm, more preferably within the range of about 360 nm to about 420 nm. For example, in the embodiment depicted in FIG. 3A, the first LED species may have a center wavelength of 395 nm and the second LED species may have a center wavelength of 365 nm. As used herein, the "center wavelength" wavelength constitutes the majority of the emission spectra emitted by each species, but the emission spectra is typically in the form of a very narrow distribution around the center wavelength. The LED array 130A in FIG. 3A is configured with each of the species of LEDs disposed adjacent one another in a repeating sequence of staggered, alternative rows, in which the first LED species 132 is disposed in a first row, the second species 134 is disposed in a second row, and the species alternate row by row thereafter. Although depicted in FIG. 3A with 10 rows (5 rows of each species), the invention is not limited to any particular number of rows, although preferably, the array has an equal number of rows of each species. As used herein the term "staggered rows" refers to rows in which elements in the second row align with spaces between adjacent elements in the first row. Another way to characterize staggered rows is to consider each member in each row as being aligned in evenly-spaced columns, with the rows and columns sequentially numbered starting from the upper row numbering downward and starting from the leftmost column numbering rightward, in which each member in odd numbered rows is aligned in the odd numbered columns (with no members in the even numbered columns) and each member in even numbered rows is aligned in the even numbered columns (with no members in the odd numbered columns).

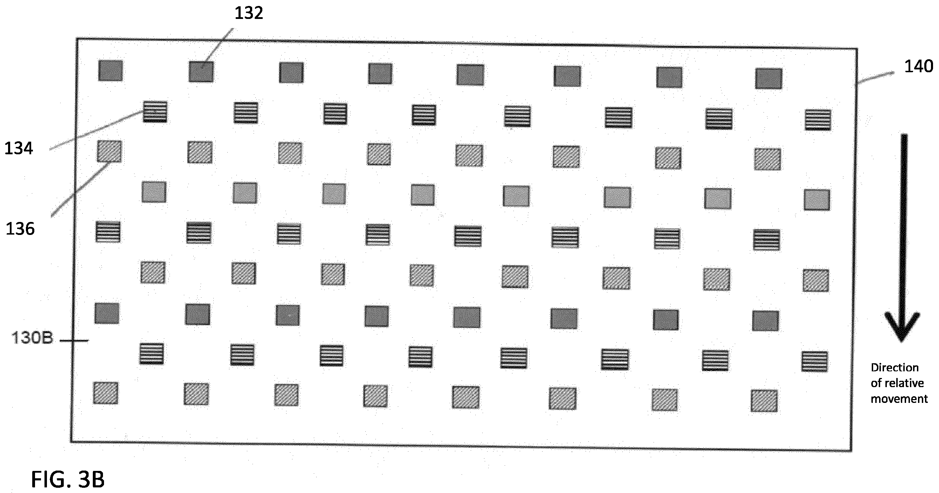

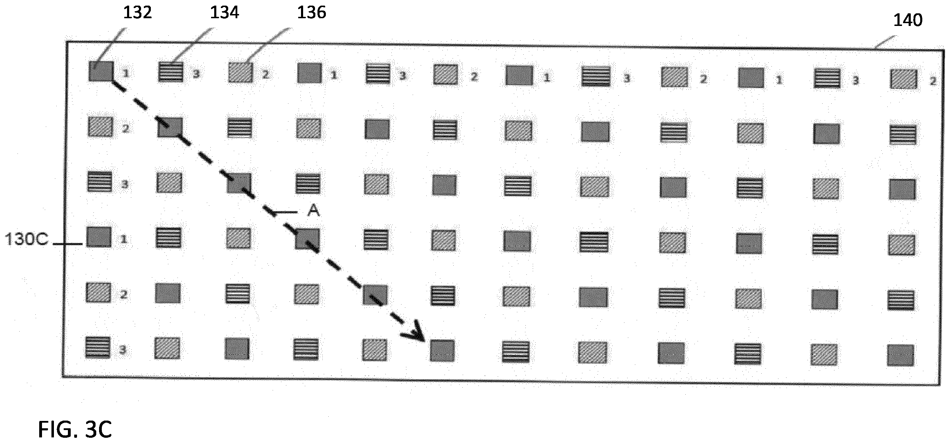

FIG. 3B depicts another example of an LED array 130B, which includes a first species of LED 132 having a first center wavelength, a second species of LED 134 having a second center wavelength different from the first center wavelength, and a third species of LED 136 having a third center wavelength different from the first and the second center wavelengths. The LED array 130B in FIG. 3B is configured with staggered rows of each species of LEDs disposed in a repeating sequence of the first LED species 132 in a first row, second LED species 134 in a second row, and the third LED species 136 in a third row. In the array depicted in FIG. 3C, example, the sequence repeats three times for a total of nine rows, but the invention is not limited to any particular number of rows, although preferably the number of rows is a multiple of the number of different LED species.

The output intensity of an LED may be controlled by changing the drive current supplied to the LEDs. In one embodiment, the intensities of the different species of wavelengths of the UV LED light assemblies are varied to produce relief printing dots having the desired geometric characteristics as described in US Patent No. 8,227,769, owned by the Applicant of the present invention. Beyond the advantages described in US Patent No. 8,227,769 for imaging the front (printing) side of a plate with a mix of wavelengths and intensities, there are also certain advantages to being able to provide a mix of wavelengths with variable intensity for exposing the back (non-printing) side of a plate. Various factors during production of the LED influence the center wavelength, and therefore the center wavelength of LEDs may vary from one batch to another. Similarly, attributes of printing plates may also vary from batch to batch. Thus, providing a plurality of LED wavelengths with variable intensity may permit optimized control of the LED wavelength and intensity to compensate for variation in particular batches of arrays or plates so that, for example, a shop running multiple lines can optimize efficiency and provide repeatability from line to line, and shops with single or multiple lines can achieve batch-to-batch repeatability for different batches of plates. Applicants have found that the ability to optimize and tune for efficiency and repeatability may have significant benefits both with respect to front (printing) side exposure as well as back (non-printing) side (floor) exposure.

For example, the ability to control intensity of one species of LED different from the corresponding intensity of another species of LED, enables a user to tune relative intensities of the respective species of LEDs to compensate for a detected difference between one batch of plates versus another batch of plates. Thus, the relative intensities may be tuned so that operation at a same set of operating conditions but for the differences in relative intensity produce results within a desired degree of deviation for different batches of plates, despite detected differences in sensitivity to actinic radiation in the different batches of plates, which sensitivity may be wavelength specific, may be caused by any aspect of the plate construction, and may impart commercially significant sensitivity with respect to a front side exposure, a back side exposure, or both. The ability to tune relative intensities of the respective species of LEDs in a plurality of exposure systems may allow users to compensate for detected differences between the respective exposure systems, such that the exposure systems as tuned can produce results within a desired degree of deviation at identical operating conditions except for the compensating differences in the relative intensities.

As illustrated in FIGS 3A - 3D, each LED has a rectangular aperture in which the length of the apertures of each of the first, second and the third LED species 132, 134 and 136 in the direction of relative movement is smaller than the width of the corresponding apertures. The invention is not limited to any particular aperture geometry, however, and the aperture may be square, or rectangular with the length greater than the width.

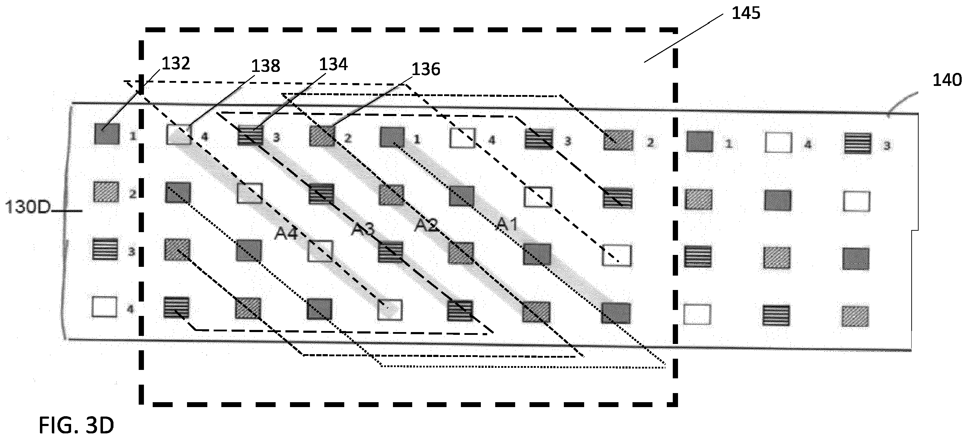

In the arrays 130C and 130D, shown respectively in FIGS 3C and 3D, each row contains each of the multiple LED species, adjacent rows are aligned on center rather than staggered, and adjacent LEDs of the same species in adjacent rows are aligned along a diagonal (as depicted by arrow A). As used herein, the term "on center" means that the center points of LEDs in adjacent rows are aligned in columns such that each row has members aligned in each column. As illustrated in FIG. 3D, each of the rows include the first, the third and the second species 132, 134 and 136 respectively in sequence, and the first row starts with the first species 132, the second row starts with the third species 136, and the third row starts with the second species 134, and those respective patterns repeat. This results in adjacent LEDS of each of the species aligned diagonally down and to the right as depicted for species 132 along arrow A, with each species aligning along diagonals parallel to arrow A. The invention is not limited to any particular pattern or order of LED species in the same row or in adjacent rows, but whatever order is selected is preferably repeated consistently. In exemplary embodiments of the arrangement depicted in FIG. 3D, the first LED species 132 may emit radiation with a center wavelength of 395 nm, the second LED species 134 may emit radiation with a center wavelength of 365 nm and the third LED species 136 may emit radiation with a center wavelength of 415 nm. Although not limited to any particular wavelengths, Applicant has found that the use of wavelengths of 365 nm or above in some applications is generally more efficient than wavelengths less than 365 nm.

The exemplary array depicted in FIG. 3D applies a repeating pattern in each row with a repeating pattern of rows on-center, each row starting with a different species, for LEDS with four different center wavelengths, such that each of LED species align along respective diagonals A4, A3, A2, and A1. The diagonals depicted in FIGS. 3C and 3D may have an angle of orientation relative to row of LEDs of, for example, 45°, or angles of 30° or 60°. The invention is not limited to any particular angle for the diagonal, which may be dependent upon the dimensions of the aperture and the number of LEDs in a row.

The array of LEDs as described herein may comprise a plurality of subarrays or units, such as 7x4 subarray 145 depicted in FIG. 3D, each of which comprising only a portion of the full array that constitutes a source. LEDs of the same species may be electrically connected together in each subarray or unit, as shown schematically by dashed lines having corresponding different dash characteristics for each species connecting the common members of each species together. Each species in the subarray may have a common subcontroller or driver. The use of subarrays in which each species in the subarray has a dedicated subcontroller or driver leads to the capability of controlling the radiation characteristics in one subarray or unit differently than in another. For example, in a linear source, discretely controllable subarrays may be used for providing a different overall radiation intensity or a different blend of species intensities in one linear portion of the source as compared to another, simultaneously. Such capability may be particularly useful when attempting to discern ideal radiation characteristics for a particular plate. For example, as described in U.S. Provisional Patent Application Ser. No. 63/008217, titled SYSTEMS AND METHODS FOR OPTIMIZATION OF PARAMETERS FOR EXPOSING FLEXOGRAPHIC PHOTOPOLYMER PLATES, a subarray construction may be harnessed to increase the number of samples that can be created with a single exposure procedure on a single photopolymer plate. By dividing the full array into two or more subarrays, each subarray may be provided with a different collective light intensity and/or a different blend of relative intensities of the different wavelength species, which permits exposure of two or more polymer plate portions simultaneously to different exposure characteristics along the dimension of the linear source. Each unit may be also be configured to emit different emission characteristics in different portions of an exposure duration. For example, the same unit may emit with different emission characteristics, preferably in stepwise changes, in different portions of the relative motion between the plate and the source and/or in different steps of a multi-step exposure, including providing no exposure during one or more steps or portions. Such functionality enables exposing different portions of the same plate to a myriad of exposure characteristics. Although depicted as a subarray of a linear source, the use of subarrays is not limited to any particular design, and may be applied to a planar source that fully covers both the length and width of the plate (such as, but not limited to, for flood or back-exposures), with discretely-controllable subarrays forming a grid. Units in such a planar source may emit with different characteristics simultaneously or in different portions of the exposure duration. Although depicted in an embodiment with four species, embodiments with individually controllable subarrays are not limited to any particular number of species, and may also be useful in single species designs.

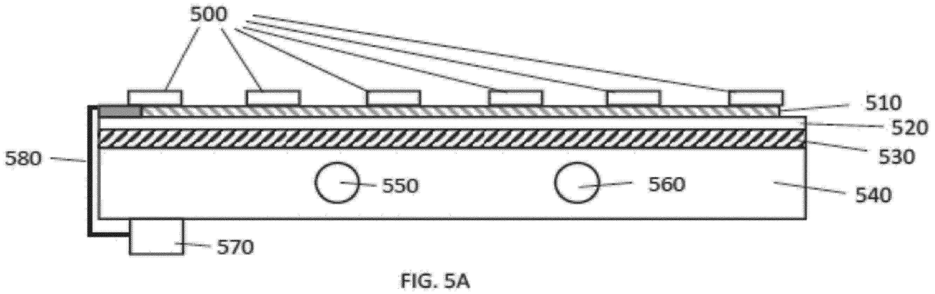

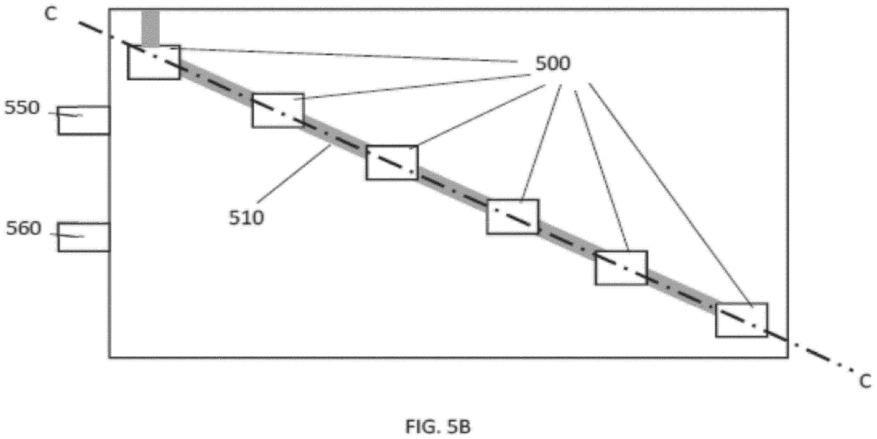

Wiring connections among the LEDs of the same species may be realized with a metal core PCB or insulated metal substrate PCB, such as BERGQUIST^{®} THERMAL CLAD Insulated Metal Substrates (TCLAD^{®}) made by Henkel, comprising a multilayer construction. FIGS. 5A and 5B depict an exemplary array SMD LEDs 500 mounted on such a multilayer PCB (layers 510, 520, 530) mounted on a cooling plate 540. Only a single diagonal of one species of LEDs 500 is depicted in FIG. 5B, for reduced clutter. The multilayer PCB is depicted in cross section along line C-C as shown in FIG. 5B. The insulated metal substrate PCB comprises a metal base heat sink layer 530 (e.g. copper or aluminum of 1 to 5 mm thickness), a thinner conductive wiring layer 510 (e.g. copper of several 10 um to several 1/10 mm) for connecting electronic components, such as the SMD LEDs 500. Layers 510 and 530 are insulated from one another by a thin dielectric layer 520 (e.g. ceramic or epoxy resin). Such boards are state of the art in LED lightning applications and are available at relatively low costs.

The arrangements depicted in FIGS. 3C, 3D, 5A, and 5B permit advantageous electrical routing along the diagonals of identical center wavelengths to the long side of the array. In preferred embodiments, the array is placed on one side of a cooling plate (e.g. a fluid cooled plate) 540 having an inlet and outlet ports 550, 560 for the fluid (e.g. water) to enter and exit the plate, with the drive electronics located on the other side of the cooling plate. Thus, in such embodiments, it may be advantageous to route wiring 580 connected to the wiring layer 510 of the PCB connecting common species of LEDs 500 around the edge of the cooling plate 540 to drive electronics 570 located on the opposite side of the cooling plate.

For embodiments having *n* different wavelengths, the number of LEDs in the direction of relative movement between the light source 105 and the polymer plate 103 (i.e. rows of LEDs) is preferably a multiple of *n*. Likewise, the number of LEDs across the width of the array in the configurations depicted in FIGS. 3C and 3D is also preferably a multiple of *n.* The invention is not limited to embodiments having such constructions, however.

Referring back to FIG.1, controller 107 controls the drive mechanism 109 to rotate the rotatable drum 101 on which the plate 103 is placed to produce a relative motion between the exposure unit 105 and the plate 103. If the exposure unit has a width less than the full width of the plate on the drum (not shown), the light exposure unit may be configured to move back and forth longitudinally, and the controller may control that longitudinal movement as well.

In some embodiments, controller 107 may also encompass the drivers 570 that independently control each LED species 500 as depicted in FIG. 5A (e.g. wherein each species comprises 132, 134 and 136 as depicted in FIG. 3D) in light exposure unit 105. Controller 107 may be configured to cause all of the LED species to emit at a common intensity, or may be configured to control each LED species to have a different intensity. The intensity for each LED species is preferably independently controllable, and variable controllable by interactive user input. Controller 107 is depicted schematically in FIG. 1, and may comprise a single control unit, such as a programmable logic controller (PLC) capable of independently controlling many inputs and outputs, or may comprise a plurality of coordinated subcontrollers or drivers of each of the motors, LED species, and the like. As used herein, the term "controller" refers to any configuration of one or more controllers and/or coordinated subcontrollers operable to provide the functionality as discussed herein.

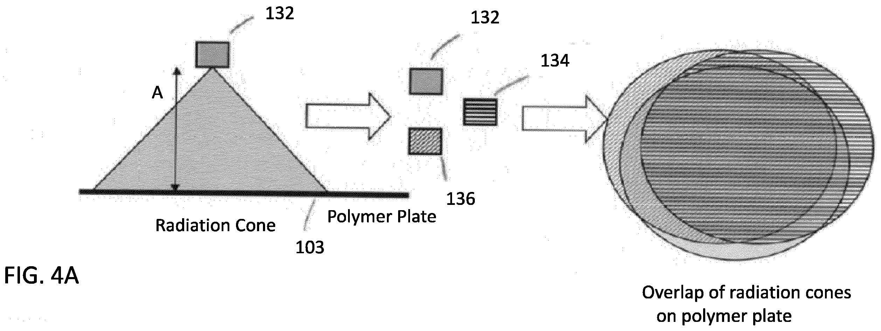

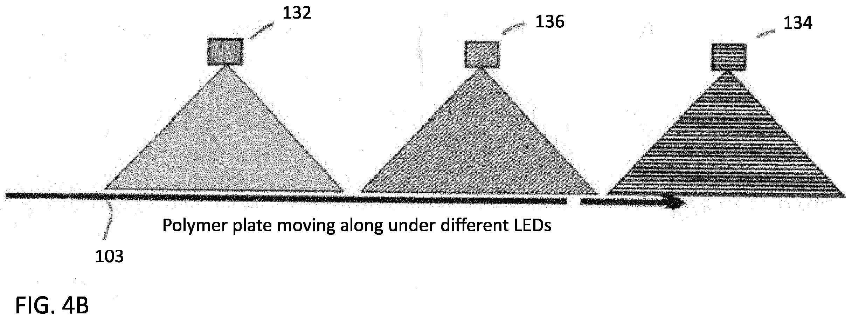

In operation, controller 107 activates the LED array, causes all LED species to emit radiation towards the plate 103 simultaneously. This simultaneous emission results in emission patterns of adjacent members of, e.g., the first, second and the third species of LEDs 132, 134 and 136 respectively to overlap with one another on the plate 103, as illustrated in FIG. 4A. In the schematic embodiment depicted in FIG. 4A, the first, second and the third species of LEDs 132, 134 and 136 are located in a sufficient distance A to the polymer plate 103 to produce sufficiently overlapping radiation cones of different wavelengths on the plate 103. The geometry of the optical radiation cone for LEDs containing more that 83% or 1/ e² of the total emitted radiation power can be measured or is known for a given LED. Accordingly, the distance A (and spacing of adjacent LEDs of different species in the array, such as in the embodiments depicted in FIGS. 3D and 3E) are selected such that the overlapping radiation cones of first, second and the third species of LEDs 132, 134 and 136 respectively of different wavelengths result in a homogenous illumination on the surface of the plate 103 as shown in FIG. 4A.

In general, in a preferred arrangement, the plurality of LEDs are relatively evenly distributed so as to be evenly spaced from neighboring LEDs, with the total number of LEDs dictated by (a) the required power per surface unit to create the desired degree of exposure for the polymer, (b) the maximum power emitted by each LED, (c) the distance the of LEDs to the surface, and (d) the geometry of the radiation cone, in order to provide an acceptably homogeneous illumination of the surface. An arrangement that produces a homogenous illumination by each species is preferred. The arrays of LED sources may be mounted in a location at or near one end of a light tunnel or kaleidoscope, such as is described in US Pat. No. 8,578,854. The use of such a light tunnel or kaleidoscope is known to create a generally acceptable level of homogeneity for the light sources.

While not limited to any particular size of the array or the LEDs, the multi-species LED arrangement may be implemented using LEDs in an arrangement similar to that currently used for single wavelength LEDs, which implementations are also known to provide a suitable degree of homogeneity of illumination. For example, in one exemplary system, an array of approximately 600 SMD LEDs are deployed in an area measuring approximately 1300x78 mm. Each SMD LED source may itself comprise an array of single-wavelength LEDs. The array in the 1300 mm dimension covers a full dimension of a plate to be exposed in the relevant dimension, and the 78 mm dimension is moved relative to a fixed plate. In that arrangement, each LED may be spaced approximately 13 mm apart, resulting in an array of 100 x 6 (600) LEDs. Such an array with the foregoing dimensions may be suitable for a 2 species system (in which 300 of each species are provided) without adjustment. Preferably, each number of rows and columns is evenly divisible by the number of LED species to produce an integer. Accordingly, for example, a three species system with approximately the same footprint as set forth above may have an array of 99 x 6 (or 102 x 6) SMD LEDs, in which case the overall dimensions or the relative spacing of the illumination area may be adjusted accordingly. Likewise, suitable arrays for a four species system may be 100 x 8, for a five species system may be 100 x 5, and so on. The invention is not limited, however, to any particular sizes or dimensions of the array, or number or size of LEDs. Although, preferably, the larger of the two numbers in the array corresponds to the number of columns of LEDs and the smaller of the two numbers corresponds to rows, the invention is not so limited. However, in embodiments in which each row is a different species, an arrangement with a smaller number of rows may have an advantage of requiring less complex wiring to provide independent control of each species. Although described above in connection with an SMD LED embodiment, it should be understood that each array may also be composed of COB LED sources, in which case each discrete LED source as described herein as being arranged in the array may comprise a COB LED, which COB LED itself comprises an array of tiny LEDs that are all the same wavelength.

In embodiments such as the arrays depicted in FIGS 3A and 3B, the LEDs of different species arranged in a alternating rows creates an exposure by which the plate 103 is moved in succession beneath the sequence of light cones created by the alternating rows of the LEDs as illustrated in 4B.

The plate 103 has a length and a width. In one embodiment, the LED array has a width that irradiates full width of the plate simultaneously, but not the full length of the plate in which case relative motion between the array and the plate in the lengthwise direction provides the desired full exposure over time. In other embodiments, the LED array irradiates less than a full width and less than a full length of the plate 103 simultaneously, and additional relative movement between the array and the plate in the longitudinal direction is necessary to provide full exposure over time. In still other embodiments, the LED array irradiates full width and length of the plate 103 simultaneously. In some embodiments, it may be desirable to provide the full calculated exposure in fractional amounts over multiple passes or irradiation steps to minimize overheating of the LEDs or the printing plate or for finer control of the exposure process.

As depicted in FIG. 1, apparatus 100 is positioned to expose a front, printing side of the printing plate 103 and comprises a drum configuration. Other embodiments may be configured to expose the back side of the printing plate, either independently, or at the same time as the front side. Any of the arrangements as discussed herein may be configured to expose the back side and the front side of the plate with a delay between front and back exposures, as is further described in U.S. Patent Application Ser. No. 15/926,616, owned by the Applicant of the present invention.

The back side of a plate may also be exposed in a drum configuration, in accordance with the arrangement depicted in FIG. 2C. Other embodiments may comprise flatbed arrangements, as depicted in FIGs. 2A and 2B.

In the embodiment 700 depicted in FIG. 2C, printing plate 730 may be mounted on a transparent (e.g. glass) cylinder 760 rotating at a predetermined speed, with the main radiation source 710 (comprising any of the array arrangements as described herein) disposed in a first location along the cylindrical path of rotation adjacent the external surface of the cylinder, and the back side radiation source 720 (comprising any of the array arrangements as described herein) disposed in a second location along the cylindrical path of rotation adjacent the internal surface of the cylinder. The respective locations of the sources may be spaced apart by a distance to provide a desired time delay required at the speed of rotation. In such a system, the location of the light sources and/or the speed of rotation may be variable to provide different time delays. The photosensitive printing plate 730 may be a sleeve, such as a sleeve designed to fit over the transparent cylinder 760 of the system described above, or may be flat, but sufficiently flexible, to permit it to be disposed on and secured to the surface of the cylinder. It should be understood that the term "transparent" as used herein may refer to any material that permits a desired amount of radiation at the desired wavelength pass through the selected material. Thus, "transparent" as used herein, may refer to a material that is not visibly transparent or even translucent to the human eye.

In the embodiment depicted in Fig. 2A, a first linear radiation source 1122 (comprising any of the array configurations described herein) may be mounted on carriage 1130 arranged to irradiate the back side of a plate 1114 mounted on transparent surface 1112, such as a glass plate, and a second linear source 1120 comprising any of the array configurations described herein) may be mounted on carriage 1130 arranged to irradiate the top side of the plate. Each linear source extends to cover one dimension of the plate, which in the example shown shall be referred to as the transverse direction. The carriage traverses the plate in the longitudinal (or lateral) direction along arrow L, with at least one source, and preferably both sources, activated. While the exposure step may be performed in a single pass, in some embodiments the exposure may be performed in a plurality of passes, in which each pass imparts radiation using both banks of sources at a fraction of the total exposure needed to provide a desired amount of exposure. As will be understood, the carriage may have a first speed when traversing the plate along the direction of arrow L with radiation sources activated, and a second, faster speed when traversing the plate in the direction opposite arrow L, to reset for another pass or at the completion of the desired number of passes.

The overall mechanism for creating the exposure may comprise a table having an outer frame 1110 that holds a transparent (e.g. glass) inner portion 1112. The upper 1120 and lower 1122 linear radiation sources (e.g. arrays of LEDs as described herein) are mounted on a gantry system or carriage 1130. The radiation sources are connected to a power source, such as an electrical power cord having sufficient slack to extend the full range of motion of the carriage. Tracks (not shown) disposed on the outer frame portion provide a defined path for the gantry system or carriage to traverse. The carriage may be moved on the tracks by any drive mechanism known in the art (also coupled to the power supply and the controller), including a chain drive, a spindle drive, gear drive, or the like. The drive mechanism for the carriage may comprise one or more components mounted within the carriage, one or more components fixed to the table, or a combination thereof. A position sensor (not shown) is preferably coupled to the carriage to provide feedback to the controller regarding the precise location of the carriage at any given time. The control signal output from the controller for operating the radiation sources and for controlling motion of the carriage may be supplied via a wired or wireless connection. The controller may be mounted in a fixed location, such as connected to the table with a control signal cable attached to the sources similar to the power cable, or may be mounted in or on the carriage. The control system and drive mechanism cooperate to cause back/forth relative motion in a transverse direction between the light from the radiation sources and the plate. If should be understood that other embodiments may be devised in which the drive mechanism is configured to move the portion of the table containing the plate past stationary upper and lower linear radiation sources, as well as embodiments in which the radiation sources cover less than the full width of the plate and are movable in both the transverse and longitudinal direction to provide total plate coverage (or the plate is movable in both directions, or the plate is movable in one of the two directions and the sources are movable in the other direction to provides the full range of motion required to cover the entire plate). In one work flow configuration, the table for conducting the exposure step (i.e. exposure table) as described above may be positioned to automatically receive an imaged plate from an imager. For example, an imager may be positioned so that the imaged plate expelled therefrom lands in a first location, and a robotic handling device may be configured to automatically pick up and move the imaged plate from the first location to a processing location on the exposure table, where the exposure process as described herein is then performed using transverse linear sources attached to a carriage that traverses the plate longitudinally.

In the exemplary embodiment 800 depicted in FIG. 2B, one or more collective radiation sources 810, 820 may be configured to emit a planar radiation field that is at least coextensive with both lateral dimensions (length, width) of plate 830 (e.g. each collective radiation source 810, 820 may be configured to irradiate the entire plate surface all at once when activated, if configured to be activated in that manner). Although depicted with both a front side radiation source and a back side radiation source, embodiments may be configured to provide only one or the other. Each source 810, 820 comprises a plurality of individual LED point sources (in any of the array configurations as described hererin). Controller 850 may be configured to create a delay time by creating a time difference between turning on a portion of source 820 for exposing the back surface and turning on a portion of source 810 for exposing the main surface. The printing plate 830 may lay flat on a horizontal transparent (e.g. glass) plate 860 or may hang in a vertical orientation. The plurality of LEDs may be coordinated and controlled to emit simultaneously, or activated in a desired pattern. For example, the individual subsources may be independently controlled so that fewer than all of the individual subsources comprising source 810 are turned on at the same time and fewer than all of the individual subsources comprising source 820 are turned on the same time. If desired, the collective subsources may be controlled in any pattern that provides a desired time delay and avoids simultaneously irradiating the front and the back of the plate by subsources that are spatially aligned with one another relative to the same coordinates of the plate.

One exemplary control pattern may activate the radiation subsources in a sequence that causes relative motion between the radiation field and the plate, such as a movement that essentially mimics the same light patterns that would be provided by main and back linear sources attached to a carriage, but with the advantage of having no moving parts. The illumination pattern may be configured to illuminate multiple portions of the front and back simultaneously (e.g. such as in a pattern that mimics multiple carriages - one starting at one end of the plate, and one starting in the middle). The illumination pattern in such a configuration is not constrained to patterns that mimic one or more carriages, however, and may be implemented in any pattern that provides the desired time delay, overall exposure, and lack of simultaneous exposure from front and back for any particular cross sectional coordinate of the plate. The pattern may also comprise illuminating the entire back at once and then the entire front, either in a single exposure for each side, or in fractional exposures of the full required exposure for each side, with the desired time delay applied between each front and back exposure. Furthermore, although shown in a flat configuration, it should be understood that systems in which both the plate and the sources are stationary may also be arranged in a cylindrical configuration.

It should be noted that the arrays as described herein may be configured for use in connection with exposure of printing plates in connection with any method or apparatus known in the art, and methods and apparatus of use are not limited to those described herein as examples. Additionally, the methods and apparatus as described herein may be combined in a workflow. For example, the front side of a plate may be exposed using a drum system such as is depicted schematically in FIG. 1, and the back side may be exposed using a flatbed system as depicted schematically in FIG. 2B.

Note that when a method is described that includes several steps, no ordering of such steps is implied, unless specifically stated.

It will also be understood that embodiments of the present invention are not limited to any particular Implementation and that the invention may be implemented using any appropriate techniques for implementing the functionality described herein. Furthermore, embodiments are not limited to any particular operating system.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill skilled in the art from this disclosure, in one or more embodiments.

In the description provided herein, numerous specific details are set forth. However, it is understood that embodiments of the invention may be practiced without these specific details. In other instances, well-known methods, structures and techniques have not been shown in detail in order not to obscure an understanding of this description.

As used herein, unless otherwise specified, the use of the ordinal adjectives "first", "second", "third", etc., to describe a common object, merely indicate that different instances of like objects are being referred to, and are not intended to imply that the objects so described must be in a given sequence, either temporally, spatially, in ranking, or in any other manner.

In the claims below and the description herein, any one of the terms comprising, comprised of or which comprises is an open term that means including at least the elements/features that follow, but not excluding others. Thus, the term comprising, when used in the claims, should not be interpreted as being limitative to the means or elements or steps listed thereafter. For example, the scope of the expression a device comprising A and B should not be limited to devices consisting of only elements A and B. Any one of the terms including or which includes or that includes as used herein is also an open term that also means including at least the elements/features that follow the term, but not excluding others. Thus, including is synonymous with and means comprising.

Similarly, it is to be noticed that the term coupled, when used in the claims, should not be interpreted as being limitative to direct connections only. The terms "coupled" and "connected," along with their derivatives, may be used. It should be understood that these terms are not intended as synonyms for each other. Thus, the scope of the expression a device A coupled to a device B should not be limited to devices or systems wherein device A is directly connected to device B. It means that there exists a path between the device A and the device B which may be a path including other devices or means. "Coupled" may mean that two or more elements are either in direct physical or electrical contact, or that two or more elements are not in direct contact with each other but yet still co-operate or interact with each other.

## Claims

1. An apparatus for exposing a printing plate (1114) to actinic radiation, the printing plate (1114) comprising a photosensitive polymer activated by such actinic radiation, the apparatus comprising:
a plurality of light-emitting diodes, LEDs, (132, 134) arranged in an array (130A, 130B, 130C, 130D) of columns and rows, each LED (132, 134) having an emission pattern and the array being positioned to expose a back, non-printing side of the printing plate (1114), the plurality of LEDs comprising a plurality of species of LEDs including at least a first species (132) and a second species (134) of LEDs, each species having a plurality of members each having a common center emission wavelength that is different than members of any other species, the array configured with the respective species of LEDs disposed adjacent one another in a repeating sequence, wherein the repeating sequence comprises:
a) alternating rows consisting of a single species in the row; or
b) alternating species in each row with adjacent members of the same species in adjacent rows aligned along a diagonal;
at least one controller connected to the LED array (130A, 130B, 130C, 130D), the at least one controller configured to independently control each of the first (132) and second species (134) and to activate the LED array (130A, 130B, 130C, 130D) to cause the first (132) and second (134) species of LEDs to emit the actinic radiation toward the printing plate simultaneously with emissions patterns of adjacent members of the first and second species of LED overlapping with one another on the plate.

2. The apparatus of claim 1, consisting of two, three, or four species (132, 134, 136) of LEDs.

3. The apparatus of claim 1 or 2, wherein the alternating rows consisting of a single species in the row are disposed in a staggered configuration such that LEDs in a second row align with spaces between adjacent LEDs in a first row; and/or
wherein the members of each species of LEDs are electrically connected to a common driver configured to cause each of the electrically connected members to emit at a common intensity.

4. The apparatus of any of claims 1-3, wherein the plate has a length and a width, and the array is configured to irradiate a full width and/or full length of the plate.

5. The apparatus of any of claims 1-3, wherein the array is configured to irradiate less than a full width and/or less than a full length of the plate simultaneously, further comprising means for providing relative movement between the array and the plate.

6. The apparatus of claim 5, wherein the means for providing relative movement comprises a drum (720) configured to receive a plate (730) mounted thereon and configured to move the plate (730) relative to the LED array (720); or
wherein the means for providing relative movement comprises a carriage (1130) for moving the LED array (1122) relative to the plate in a flatbed configuration.

7. The apparatus of claim 5, wherein the array (130A, 130B, 130C, 130D) comprises one of a plurality of units arranged to form a linear source configured to irradiate the width of the plate simultaneously but less than the length of the plate simultaneously, the means for providing relative movement being configured to provide relative movement between the plate and the linear source along the length of the plate.

8. The apparatus of claim 7, wherein each of the plurality of units has one or more user adjustable emission characteristics; and
wherein optionally the plurality of units is configurable to permit one unit to emit a different emission characteristic than another unit simultaneously, or
wherein optionally the plurality of units is configurable to permit the same unit to emit different emission characteristics during different portions of an exposure duration.

9. The apparatus of any one of claims 1-8, wherein the LED array (130A, 130B, 130C, 130D) includes a plurality of subarrays that are controlled by a plurality of subcontrollers, respectively, and one of the plurality of subarrays has radiation characteristics different from another one of the plurality of subarrays.

10. A method for exposing a printing plate using the apparatus of any of the foregoing claims, the method comprising:
providing the plurality of LEDs arranged in the array (130A, 130B, 130C, 130D); and
activating the LED array (130A, 130B, 130C, 130D) to cause each species of LEDs to emit actinic radiation toward the printing plate simultaneously.

11. The method of claim 10, further comprising providing an intensity of one species (132) of LED that is different than a corresponding intensity of another species (134) of LED; or
further comprising tuning relative intensities of the respective species of LEDs to compensate for a detected difference in exposure sensitivity between one batch of plates relative to another batch of plates so that operation at a same set of operating conditions except for differences in relative intensities produce results within a desired degree of deviation for the respective batches of plates despite the differences in exposure sensitivity.

12. The method of claim 10 or 11, further comprising tuning relative intensities of the respective species of LEDs in a plurality of exposure systems to compensate for detected differences between the respective exposure systems, such that at least one set of relative intensities for one exposure system is different from at least another set of relative intensities for another exposure system, such that the one and the another exposure systems as tuned produce results within a desired degree of deviation at identical operating conditions but for the relative intensities.

13. A method for exposing a printing plate using the apparatus of claim 7, the method comprising:
providing the linear source comprising the plurality of units, each unit comprising the plurality of LEDs arranged in the array (130A, 130B, 130C, 130D);
activating the linear source to cause each species of LEDs in each unit to emit actinic radiation toward the printing plate simultaneously;
controlling relative motion between the linear source and the plate during the exposure;
controlling at least one unit to provide a different radiation characteristic than at least one other unit; and
the at least one unit providing a first radiation characteristic in a first portion of the relative motion and a second radiation characteristic in a second portion of the relative motion.

14. A method for exposing a printing plate using the apparatus of claim 8, the method comprising:
providing a planar source comprising the plurality of units, each unit comprising the plurality of LEDs arranged in the array (130A, 130B, 130C, 130D);
activating the planar source to cause each species (132, 134) of LEDs in each unit to emit actinic radiation toward the printing plate simultaneously;
controlling at least one unit to provide a different radiation characteristic than at least one other unit, including controlling the least one unit to provide the different radiation characteristic than the at least one other unit simultaneously or controlling the at least one unit to provide a different radiation characteristic during one portion of an exposure period than in a different portion of the exposure period.

15. The method of claim 13 or 14, wherein the different radiation characteristic is a different collective emission intensity or a different blend of relative emission intensities from the respective species.

## Patentansprüche

1. Eine Vorrichtung zum Belichten einer Druckplatte (1114) mit aktinischer Strahlung, wobei die Druckplatte (1114) ein lichtempfindliches Polymer umfasst, das durch solche aktinische Strahlung aktiviert wird, wobei die Vorrichtung Folgendes umfasst:
eine Vielzahl von Leuchtdioden (LEDs) (132, 134), die in einem Array (130A, 130B, 130C, 130D) aus Spalten und Reihen angeordnet sind, wobei jede LED (132, 134) ein Emissionsmuster aufweist und das Array positioniert ist, um eine rückseitige, nicht druckende Seite der Druckplatte (1114) zu belichten, wobei die Vielzahl von LEDs eine Vielzahl von LED-Spezies umfasst, einschließlich zumindest einer ersten Spezies (132) und einer zweiten Spezies (134) von LEDs, wobei jede Spezies eine Vielzahl von Elementen aufweist, die jeweils eine gemeinsame zentrale Emissionswellenlänge besitzen, die sich von derjenigen der Elemente jeder anderen Spezies unterscheidet, wobei das Array derart konfiguriert ist, dass die jeweiligen LED-Spezies in einer sich wiederholenden Sequenz nebeneinander angeordnet sind, wobei die sich wiederholende Sequenz Folgendes umfasst:
a) alternierende Reihen, die jeweils aus einer einzigen Spezies in der Reihe bestehen; oder
b) in jeder Reihe alternierende Spezies, wobei benachbarte Elemente derselben Spezies in benachbarten Reihen entlang einer Diagonale ausgerichtet sind;
mindestens eine Steuereinrichtung, die mit dem LED-Array (130A, 130B, 130C, 130D) verbunden ist, wobei die mindestens eine Steuereinrichtung konfiguriert ist, um jede der ersten (132) und zweiten Spezies (134) unabhängig voneinander zu steuern, und um das LED-Array (130A, 130B, 130C, 130D) zu aktivieren, um die erste (132) und zweite (134) Spezies von LEDs zu veranlassen, die aktinische Strahlung gleichzeitig in Richtung der Druckplatte zu emittieren, wobei sich die Emissionsmuster benachbarter Elemente der ersten und zweiten Spezies von LEDs auf der Platte überlappen.

2. Die Vorrichtung nach Anspruch 1, bestehend aus zwei, drei oder vier Spezies (132, 134, 136) von LEDs.

3. Die Vorrichtung nach Anspruch 1 oder 2, wobei die alternierenden Reihen, die aus einer einzigen Spezies in der Reihe bestehen, in einer versetzten Konfiguration angeordnet sind, sodass LEDs in einer zweiten Reihe mit Zwischenräumen zwischen benachbarten LEDs in einer ersten Reihe ausgerichtet sind; und/oder
wobei die Elemente jeder Spezies von LEDs elektrisch mit einem gemeinsamen Treiber verbunden sind, der dazu konfiguriert ist, jedes der elektrisch verbundenen Elemente zu veranlassen, mit einer gemeinsamen Intensität zu emittieren.

4. Die Vorrichtung nach irgendeinem der Ansprüche von 1 bis 3, wobei die Platte eine Länge und eine Breite aufweist, und der Array konfiguriert ist, um die volle Breite und/oder Länge der Platte zu bestrahlen.

5. Die Vorrichtung nach irgendeinem der Ansprüche von 1 bis 3, wobei der Array konfiguriert ist, um weniger als die volle Breite und/oder weniger als die volle Länge der Platte gleichzeitig zu bestrahlen, und ferner umfassend Mittel zum Bereitstellen einer Relativbewegung zwischen dem Array und der Platte.

6. Die Vorrichtung nach Anspruch 5, wobei die Mittel zum Bereitstellen einer Relativbewegung eine Trommel (720) umfassen, die konfiguriert ist, um eine darauf montierte Platte (730) aufzunehmen, und konfiguriert ist die Platte (730) relativ zum LED-Array (720) zu bewegen; oder
wobei die Mittel zum Bereitstellen einer Relativbewegung einen Schlitten (1130) umfassen, um den LED-Array (1122) relativ zur Platte in einer Flachbettkonfiguration zu bewegen.

7. Die Vorrichtung nach Anspruch 5, wobei das Array (130A, 130B, 130C, 130D) eine von einer Vielzahl von Einheiten umfasst, die so angeordnet sind, dass sie eine lineare Quelle bilden, die konfiguriert ist, um die Breite der Platte gleichzeitig, jedoch weniger als die Länge der Platte gleichzeitig zu bestrahlen,
wobei das Mittel zum Bereitstellen einer Relativbewegung zum Bereitstellen einer Relativbewegung zwischen der Platte und der linearen Quelle entlang der Länge der Platte ausgebildet ist.

8. Die Vorrichtung nach Anspruch 7, wobei jede der Vielzahl von Einheiten eine oder mehrere vom Benutzer einstellbare Emissionscharakteristika aufweist; und
wobei optional die Vielzahl von Einheiten konfigurierbar sind, um zu gestatten, dass eine Einheit gleichzeitig ein anderes Emissionscharakteristikum als eine andere Einheit emittieren kann, oder
wobei optional die Vielzahl von Einheiten konfigurierbar sind, um zu gestatten, dass dieselbe Einheit während verschiedener Abschnitte einer Belichtungsdauer unterschiedliche Emissionscharakteristika emittieren kann.

9. Die Vorrichtung nach irgendeinem der Ansprüche von 1 bis 8, wobei das LED-Array (130A, 130B, 130C, 130D) eine Vielzahl von Subarrays beinhaltet, die jeweils durch eine Vielzahl von Untersteuereinrichtungen gesteuert werden, und wobei ein Subarray aus der Vielzahl von Subarrays andere Strahlungscharakteristika aufweist als ein anderes Subarray aus der Vielzahl von Subarrays.

10. Ein Verfahren zum Belichten einer Druckplatte unter Verwendung der Vorrichtung nach irgendeinem der vorstehenden Ansprüche, wobei das Verfahren Folgendes umfasst:
Bereitstellen der Vielzahl an LEDs, die im Array (130A, 130B, 130C, 130D) angeordnet sind; und
Aktivieren des LED-Arrays (130A, 130B, 130C, 130D), um zu bewirken, dass jede Spezies von LEDs gleichzeitig aktinische Strahlung in Richtung der Druckplatte emittiert.

11. Das Verfahren nach Anspruch 10, ferner umfassend: Bereitstellen einer Intensität einer Spezies (132) von LEDs, die sich von einer entsprechenden Intensität einer anderen Spezies (134) von LEDs unterscheidet; oder
ferner umfassend: Abstimmen der relativen Intensitäten der jeweiligen LED-Spezies, um einen erkannten Unterschied in der Belichtungsempfindlichkeit zwischen einer Charge von Platten und einer anderen Charge von Platten zu kompensieren, sodass ein Betrieb bei demselben Satz von Betriebsbedingungen, mit Ausnahme von Unterschieden in den relativen Intensitäten, Ergebnisse innerhalb eines gewünschten Abweichungsgrades für die jeweiligen Chargen von Platten trotz der Unterschiede in der Belichtungsempfindlichkeit erzeugt.

12. Das Verfahren nach Anspruch 10 oder 11, ferner umfassend: Abstimmen der relativen Intensitäten der jeweiligen LED-Spezies in einer Vielzahl von Belichtungssystemen, um festgestellte Unterschiede zwischen den jeweiligen Belichtungssystemen zu kompensieren, sodass mindestens ein Satz relativer Intensitäten für ein Belichtungssystem sich von mindestens einem anderen Satz relativer Intensitäten für ein anderes Belichtungssystem unterscheidet, sodass das eine und das andere Belichtungssystem, in abgestimmtem Zustand, Ergebnisse innerhalb eines gewünschten Abweichungsgrades unter identischen Betriebsbedingungen, jedoch für die relativen Intensitäten, erzeugen.

13. Ein Verfahren zum Belichten einer Druckplatte unter Verwendung der Vorrichtung nach Anspruch 7, wobei das Verfahren Folgendes umfasst:
Bereitstellen der linearen Quelle, die die Vielzahl von Einheiten umfasst, wobei jede Einheit die Vielzahl von LEDs umfasst, die im Array (130A, 130B, 130C, 130D) angeordnet sind;
Aktivieren der linearen Quelle, um zu bewirken, dass jede Spezies von LEDs in jeder Einheit gleichzeitig aktinische Strahlung in Richtung der Druckplatte emittiert;
Steuern der Relativbewegung zwischen der linearen Quelle und der Platte während der Belichtung;
Steuern zumindest einer Einheit, um ein anderes Strahlungscharakteristikum bereitzustellen als zumindest eine andere Einheit
Bereitstellen, durch die mindestens eine Einheit, eines ersten Strahlungscharakteristikums in einem ersten Abschnitt der Relativbewegung und eines zweiten Strahlungscharakteristikums in einem zweiten Abschnitt der Relativbewegung.

14. Ein Verfahren zum Belichten einer Druckplatte unter Verwendung der Vorrichtung nach Anspruch 8, wobei das Verfahren Folgendes umfasst:
Bereitstellen einer planaren Quelle, die die Vielzahl von Einheiten umfasst, wobei jede Einheit die Vielzahl von LEDs umfasst, angeordnet im Array (130A, 130B, 130C, 130D);
Aktivieren der planaren Quelle, um jede Spezies (132, 134) von LEDs in jeder Einheit zu veranlassen, gleichzeitig aktinische Strahlung in Richtung der Druckplatte zu emittieren;
Steuern zumindest einer Einheit, um ein anderes Strahlungscharakteristikum bereitzustellen als zumindest eine andere Einheit, einschließlich Steuern der mindestens einen Einheit, um gleichzeitig das andere Strahlungscharakteristikum als die zumindest eine andere Einheit bereitzustellen, oder Steuern der mindestens einen Einheit, um während eines Abschnitts einer Belichtungsdauer ein anderes Strahlungscharakteristikum als in einem anderen Abschnitt der Belichtungsdauer bereitzustellen.

15. Das Verfahren nach Anspruch 13 oder 14, wobei das unterschiedliche Strahlungscharakteristikum eine unterschiedliche kollektive Emissionsintensität oder eine unterschiedliche Mischung relativer Emissionsintensitäten der jeweiligen Spezies ist.

## Revendications

1. Un dispositif pour exposer une plaque d'impression (1114) à un rayonnement actinique, la plaque d'impression (1114) comprenant un polymère photosensible activé par un tel rayonnement actinique, le dispositif comprenant :
une pluralité de diodes électroluminescentes, LED, (132, 134) disposées dans un réseau (130A, 130B, 130C, 130D) de colonnes et de rangées, chaque LED (132, 134) présentant un motif d'émission et le réseau étant positionné de manière à exposer une face arrière, non imprimable, de la plaque d'impression (1114), la pluralité de LED comprenant une pluralité d'espèces de LED, incluant au moins une première espèce (132) et une deuxième espèce (134) de LED, chaque espèce présentant une pluralité d'éléments ayant chacun une longueur d'onde d'émission centrale commune qui est différente de celle des éléments de toute autre espèce, la matrice étant configurée avec les espèces respectives de LED disposées de manière adjacente les unes aux autres dans une séquence répétitive, sachant que la séquence répétitive comprenant :
a) des rangées alternées constituées d'une seule espèce dans la rangée ; ou
b) des espèces alternées dans chaque rangée avec des éléments adjacents de la même espèce dans des rangées adjacentes alignés le long d'une diagonale ;
au moins un dispositif de commande connecté au réseau de LED (130A, 130B, 130C, 130D),
le au moins un dispositif de commande étant configuré pour commander indépendamment chacune des espèces première (132) et deuxième (134), et pour activer le réseau de LED (130A, 130B, 130C, 130D) afin d'amener les espèces première (132) et deuxième (134) de LED à émettre le rayonnement actinique vers la plaque d'impression simultanément avec des motifs d'émission d'éléments adjacents des espèces première et deuxième de LED se chevauchant les uns les autres sur la plaque.

2. Le dispositif d'après la revendication 1, constitué de deux, trois ou quatre espèces (132, 134, 136) de LED.

3. Le dispositif d'après la revendication 1 ou 2, sachant que les rangées alternées constituées d'une seule espèce dans la rangée sont disposées selon une configuration décalée de telle manière que des LED d'une deuxième rangée sont alignées avec les espaces entre des LED adjacentes d'une première rangée ; et/ou
sachant que les éléments de chaque espèce de LED sont connectés électriquement à un pilote commun configuré pour amener chacun des éléments connectés électriquement à émettre à une intensité commune.

4. Le dispositif d'après l'une quelconque des revendications de 1 à 3, sachant que la plaque présente une longueur et une largeur, et que le réseau est configuré pour irradier la totalité de la largeur et/ou la totalité de la longueur de la plaque.

5. Le dispositif d'après l'une quelconque des revendications de 1 à 3, sachant que le réseau est configuré pour irradier simultanément moins que la totalité de la largeur et/ou moins que la totalité de la longueur de la plaque, comprenant en outre des moyens pour fournir un mouvement relatif entre le réseau et la plaque.

6. Le dispositif d'après la revendication 5, sachant que les moyens pour fournir un mouvement relatif comprennent un tambour (720) configuré pour recevoir une plaque (730) montée sur celui-ci, et configuré pour déplacer la plaque (730) par rapport au réseau de LED (720) ;
sachant que les moyens pour fournir un mouvement relatif comprennent un chariot (1130) destiné à déplacer le réseau de LED (1122) par rapport à la plaque dans une configuration de type table à plat.

7. Le dispositif d'après la revendication 5, sachant que le réseau (130A, 130B, 130C, 130D) comprend l'une d'une pluralité d'unités agencées pour former une source linéaire configurée pour irradier simultanément la largeur de la plaque, mais moins que la longueur de la plaque simultanément, les moyens pour fournir un mouvement relatif étant configurés pour fournir un mouvement relatif entre la plaque et la source linéaire le long de la longueur de la plaque.

8. Le dispositif d'après la revendication 7, sachant que chacune de la pluralité d'unités possède une ou plusieurs caractéristiques d'émission réglables par l'utilisateur ; et
sachant que, facultativement, la pluralité d'unités est configurable pour permettre à une unité d'émettre simultanément une caractéristique d'émission différente de celle d'une autre unité, ou
sachant que, facultativement, la pluralité d'unités est configurable pour permettre à la même unité d'émettre différentes caractéristiques d'émission pendant différentes portions d'une durée d'exposition.

9. Le dispositif d'après l'une quelconque des revendications de 1 à 8, sachant que le réseau de LED (130A, 130B, 130C, 130D) inclut une pluralité de sous-réseaux qui sont commandés respectivement par une pluralité de sous-dispositif de commande, et que l'un de la pluralité de sous-réseaux possède des caractéristiques de rayonnement différentes de celles d'un autre de la pluralité de sous-réseaux.

10. Un procédé pour exposer une plaque d'impression en utilisant le dispositif d'après l'une quelconque des revendications précédentes, le procédé comprenant le fait de :
fournir la pluralité de LED disposées dans le réseau (130A, 130B, 130C, 130D) ; et de
activer le réseau de LED (130A, 130B, 130C, 130D) pour amener chaque espèce de LED à émettre simultanément un rayonnement actinique vers la plaque d'impression.

11. Le procédé d'après la revendication 10, comprenant en outre le fait de fournir une intensité d'une espèce (132) de LED qui est différente d'une intensité correspondante d'une autre espèce (134) de LED ; ou
comprenant en outre le fait d'ajuster des intensités relatives des espèces respectives de LED afin de compenser une différence détectée dans la sensibilité à l'exposition entre un lot de plaques et un autre lot de plaques, de manière que le fonctionnement dans un même ensemble de conditions de fonctionnement, à l'exception des différences d'intensités relatives, produise des résultats dans un degré d'écart souhaité pour les lots respectifs de plaques, malgré les différences de sensibilité à l'exposition.

12. Le procédé d'après la revendication 10 ou 11, comprenant en outre le fait d'ajuster des intensités relatives des espèces respectives de LED dans une pluralité de systèmes d'exposition afin de compenser les différences détectées entre les systèmes d'exposition respectifs, de manière qu'au moins un ensemble d'intensités relatives pour un système d'exposition soit différent d'au moins un autre ensemble d'intensités relatives pour un autre système d'exposition, de façon que les systèmes d'exposition ainsi ajustés produisent des résultats dans un degré d'écart souhaité dans des conditions de fonctionnement identiques, à l'exception des intensités relatives.

13. Un procédé pour exposer une plaque d'impression en utilisant le dispositif d'après la revendication 7, le procédé comprenant le fait de :
fournir la source linéaire comprenant la pluralité d'unités, chaque unité comprenant la pluralité de LED disposées dans le réseau (130A, 130B, 130C, 1300) ;
activer la source linéaire pour amener chaque espèce de LED dans chaque unité à émettre simultanément un rayonnement actinique vers la plaque d'impression ;
commander le mouvement relatif entre la source linéaire et la plaque pendant l'exposition ;
commander au moins une unité pour fournir une caractéristique de rayonnement différente de celle d'au moins une autre unité ; et
la ou les unités fournissant une première caractéristique de rayonnement dans une première portion du mouvement relatif et une deuxième caractéristique de rayonnement dans une deuxième portion du mouvement relatif.

14. Un procédé pour exposer une plaque d'impression en utilisant le dispositif d'après la revendication 8, le procédé comprenant le fait de :
fournir une source plane comprenant la pluralité d'unités, chaque unité comprenant la pluralité de LED agencées dans le réseau (130A, 130B, 130C, 1300) ;
activer la source plane pour amener chaque espèce (132, 134) de LED dans chaque unité à émettre simultanément un rayonnement actinique vers la plaque d'impression ;
commander au moins une unité afin de fournir une caractéristique de rayonnement différente de celle d'au moins une autre unité, incluant le fait de commander ladite au moins une unité afin de fournir simultanément la caractéristique de rayonnement différente de celle d'au moins une autre unité ou de commander ladite au moins une unité afin de fournir une caractéristique de rayonnement différente pendant une portion d'une période d'exposition par rapport à une autre portion de la période d'exposition.

15. Le procédé d'après la revendication 13 ou 14, sachant que la caractéristique de rayonnement différente est une intensité d'émission collective différente ou un mélange différent d'intensités d'émission relatives provenant des espèces respectives.
